# EUROPEAN PATENT APPLICATION

(11) **EP 4 390 543 A1**
(43) Date of publication of application: **26.06.2024**
(21) Application number: 22216593.8
(22) Date of filing: 23.12.2022
(51) Int. Cl.: G03F 7/00

(54) **LITHOGRAPHIC SYSTEM AND METHOD**

(71) Applicant: ASML Netherlands B.V., 5500 AH Veldhoven (NL)
(72) Inventor: BECKERS, Jasper, Pierre, 5500 AH Veldhoven (NL); VAN DE WIEL, Hubertus, Johannes, 5500 AH Veldhoven (NL); TE SLIGTE, Edwin, 5500 AH Veldhoven (NL); HARRISON, Kramer, Daniel, 5500 AH Veldhoven (NL); VAN DRENT, William, Peter, 5500 AH Veldhoven (NL)
(74) Representative: ASML Netherlands B.V.

(57) **Abstract**

A lithographic system comprising a radiation source (SO) comprising a drive laser configured to generate drive laser radiation for irradiating a fuel and thereby generating extreme ultraviolet radiation. The lithographic system comprises a lithographic apparatus (LA) configured to receive extreme ultraviolet radiation directed through an optical aperture (8) located between the radiation source and the lithographic apparatus. The lithographic apparatus comprises a radiation shield (100) configured to block at least a portion (2a) of the drive laser radiation that propagates through the optical aperture.

[Fig. 2]

## Description

### FIELD

The present invention relates to a lithographic system and method, and particularly to the generation of radiation for use in lithographic systems and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic system comprises a radiation source configured to generate EUV radiation and a lithographic apparatus configured to use the EUV radiation. The radiation source comprises a drive laser configured to direct drive laser radiation towards fuel droplets (e.g. tin) and convert the fuel droplets to plasma which then emits EUV radiation. The EUV radiation is directed from the radiation source to the lithographic apparatus through an optical aperture that separates the radiation source and the lithographic apparatus. At least some drive laser radiation may propagate from the radiation source to the lithographic apparatus through the optical aperture and negatively affect one or more components of the lithographic apparatus.

Known lithographic apparatus and methods may be limited in their ability to manage drive laser radiation. It is desirable to provide a lithographic apparatus and method that obviates or mitigates one or more of the problems of the prior art, whether identified herein or elsewhere.

### SUMMARY

According to a first aspect of the present disclosure, there is provided a lithographic system. The lithographic system comprises a radiation source comprising a drive laser configured to generate drive laser radiation for irradiating a fuel and thereby generating extreme ultraviolet radiation. The lithographic system comprises a lithographic apparatus configured to receive extreme ultraviolet radiation directed through an optical aperture located between the radiation source and the lithographic apparatus. The lithographic apparatus comprises a radiation shield configured to block at least a portion of the drive laser radiation that propagates through the optical aperture.

Drive laser radiation entering the lithographic apparatus through the optical aperture may negatively affect one or more components in the lithographic apparatus. For example, unwanted thermal deformation of components such as one or more mirrors, a patterning device, a substrate, etc. caused by the drive laser radiation may reduce an imaging performance of the lithographic apparatus (such as by introducing focus and/or overlay errors) and/or damage the components and thereby reduce an operational lifetime of the components. This in turn, may necessitate more frequent repairs and/or maintenance of said optical components, thereby reducing the amount of time for which the lithographic system may remain operational. By using a radiation shield to block the drive laser radiation, the lithographic apparatus may be protected from these negative effects. However, the radiation source generates fuel debris (e.g. tin debris) in the process of generating extreme ultraviolet radiation. If the radiation shield is located in the radiation source, the radiation shield may collect fuel debris and then emit said debris when heated by the drive laser radiation. The fuel debris may travel through the optical aperture into the lithographic apparatus and negatively affect one or more components therein. For example, fuel debris may damage and/or otherwise reduce an operational lifetime of one or more mirrors of the lithographic apparatus. As another example, fuel debris may be incident on a patterning device (i.e. a reticle) present in the lithographic apparatus and thereby negatively affect imaging of said patterning device, resulting in faulty devices being manufactured by the lithographic apparatus. By locating the radiation shield in the lithographic apparatus rather than the radiation source, the present invention advantageously reduces both the amount of drive laser radiation and fuel debris entering the lithographic apparatus. The radiation shield is exposed to less fuel debris when located in the lithographic apparatus rather than the radiation source, and thereby does not act as a source of fuel debris when heated by the drive laser radiation. In addition, by locating the radiation shield in the lithographic apparatus rather than the radiation source, the radiation shield is exposed to less extreme conditions (e.g. reduced temperatures and reduced exposure to fuel debris), so greater design flexibility of the radiation shield is enabled. For example, a lower heat load may mean that the radiation shield can be less bulky and/or more compact because lower heat dissipation is required. By making the radiation shield more compact, a transmission of EUV radiation through the lithographic apparatus may be increased. Increasing the transmission of EUV radiation may in turn increase a throughput of the lithographic system.

The radiation source may be a laser produced plasma (LPP) radiation source.

The drive laser may comprise a CO₂ laser. The drive laser may be configured to generate pulsed drive laser radiation. The drive laser may be configured to generate drive laser radiation pulses having a power of about 28 kW. The drive laser may be configured to generate drive laser radiation having a wavelength within the inclusive range of between about 9 µm and about 11 µm, e.g. about 10 µm.

The optical aperture may correspond to an intermediate focus (i.e. focal point) of an EUV radiation collector present in the radiation source. The EUV radiation collector may be configured to collect EUV radiation emitted by the fuel and redirect the EUV radiation through the optical aperture.

The radiation shield comprise a metal such as, for example, Tungsten, Molybdenum, etc.

The radiation shield may be configured to block all drive laser radiation that propagates through the optical aperture.

The radiation shield may be located proximate the optical aperture. The radiation shield may be located about 10 cm or more from the optical aperture. The radiation shield may be located about 1 m or less from the optical aperture.

The lithographic apparatus may comprise an illumination system configured to condition the extreme ultraviolet radiation beam for illumination of a patterning device. The illumination system may comprise a mirror configured to reflect the extreme ultraviolet radiation. The radiation shield may be attached to the mirror.

The lithographic apparatus may comprise an illumination system configured to condition the extreme ultraviolet radiation beam for illumination of a patterning device. The illumination system may comprise a fuel shield configured to protect a component of the illumination system from fuel debris generated by the radiation source. The radiation shield may be attached to the fuel shield.

The radiation source may comprise a first beam dump configured to block at least a portion of the drive laser radiation that does not propagate through the optical aperture.

The lithographic apparatus may comprise a second beam dump. The radiation shield may comprise a mirror configured to direct the portion of the drive laser radiation that propagates through the optical aperture towards the second beam dump.

The first beam dump may be arranged on a structure that forms the optical aperture. The second beam dump may be arranged on a structure that forms the optical aperture.

The lithographic system may comprise a cooling system. The cooling system may be configured to actively cool the first beam dump. The cooling system may be configured to actively cool the second beam dump.

The radiation source may be configured to generate a cone of extreme ultraviolet radiation. The cone may comprise a hole in which no extreme ultraviolet radiation is present. The radiation shield may be located at a position in the lithographic apparatus that at least partially coincides with the hole of the cone of extreme ultraviolet radiation. The radiation shield may be located at a position in the lithographic apparatus that completely coincides with the hole of the cone of extreme ultraviolet radiation.

According to a second aspect of the present disclosure, there is provided a method of providing extreme ultraviolet radiation to a lithographic apparatus. The method comprises irradiating a fuel with drive laser radiation to generate extreme ultraviolet radiation. The method comprises directing the extreme ultraviolet radiation to the lithographic apparatus through an optical aperture. The method comprises blocking at least a portion of drive laser radiation that propagates through the optical aperture.

The method may comprise blocking all drive laser radiation that propagates through the optical aperture.

The method may comprise blocking at least a portion of the drive laser radiation that does not propagate through the optical aperture.

The method may comprise using active cooling to dissipate heat generated by blocking the portion of the drive laser radiation that does not propagate through the optical aperture.

According to a third aspect of the present disclosure, there is provided a method of manufacturing a lithographic system. The method comprises providing a radiation source comprising a drive laser configured to generate drive laser radiation for irradiating a fuel and thereby generating extreme ultraviolet radiation. The method comprises providing a lithographic apparatus configured to receive extreme ultraviolet radiation directed through an optical aperture located between the radiation source and the lithographic apparatus. The method comprises arranging a radiation shield in the lithographic apparatus to block at least a portion of drive laser radiation that propagates through the optical aperture.

The method may comprise locating the radiation shield proximate the optical aperture.

The lithographic apparatus may comprise an illumination system configured to condition the extreme ultraviolet radiation beam for illumination of a patterning device. The illumination system may comprise a mirror configured to reflect the extreme ultraviolet radiation. The method may comprise attaching the radiation shield to the mirror.

The lithographic apparatus may comprise an illumination system configured to condition the extreme ultraviolet radiation beam for illumination of a patterning device. The illumination system may comprise a fuel shield configured to protect a component of the illumination system from fuel debris generated by the radiation source. The method may comprise attaching the radiation shield to the fuel shield.

The method may comprise providing a first beam dump configured to block at least a portion of the drive laser radiation that does not propagate through the optical aperture.

The method may comprise providing a second beam dump configured to block the portion of the drive laser radiation that propagates through the optical aperture.

The method may comprise arranging the first beam dump on a structure that forms the optical aperture. The method may comprise arranging the second beam dump on a structure that forms the optical aperture.

The method may comprise providing a cooling system. The cooling system may be configured to actively cool the first beam dump. The cooling system may be configured to actively cool the second beam dump.

The radiation source may be configured to generate a cone of extreme ultraviolet radiation. The cone may comprise a hole in which no extreme ultraviolet radiation is present. The method may comprise locating the radiation shield at a position in the lithographic apparatus that at least partially coincides with the hole of the cone of extreme ultraviolet radiation.

It will be appreciated that various aspects of the invention may be combined.

### BRIEF DESCRIPTION OF THE DRAWINGS

Embodiments of the invention will now be described, by way of example only, with reference to the accompanying schematic drawings, in which:
- Fig. 1 schematically depicts a lithographic system comprising a lithographic apparatus, a radiation source and a radiation shield in accordance with an embodiment of the present disclosure;
- Fig. 2 schematically depicts a simplified view of the lithographic system of Fig. 1 at a time when at least a portion of drive laser radiation propagates through to the lithographic apparatus;
- Fig. 3 schematically depicts a lithographic system in which the radiation shield is attached to a fuel shield;
- Fig. 4 schematically depicts a lithographic system in which the radiation shield is attached to a mirror of an illumination system of the lithographic apparatus;
- Fig. 5 schematically depicts a lithographic system in which the radiation shield is configured to act as a reflector;
- Fig. 6 shows a flowchart of a method of providing extreme ultraviolet radiation to a lithographic apparatus according to an embodiment of the present disclosure;
- Fig. 7 shows a flowchart of a method of manufacturing a lithographic system according to an embodiment of the present disclosure.

### DETAILED DESCRIPTION

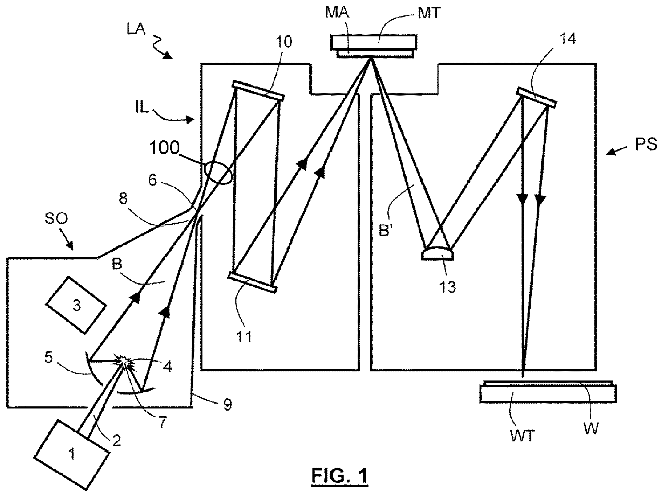

Fig. 1 shows a lithographic system comprising a radiation source SO and a lithographic apparatus LA. The radiation source SO is an extreme ultraviolet (EUV) laser produced plasma (LPP) radiation source and the lithographic apparatus LA is an EUV scanner. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a faceted field mirror device 10 and a faceted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of four or eight may be applied. Although the projection system PS is illustrated as having only two mirrors 13, 14 in Fig. 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Fig. 1 is, for example, of a type which may be referred to as a laser produced plasma (LPP) source. A drive laser 1, which may, for example, include a CO₂ laser, is arranged to deposit energy via drive laser radiation 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. molten tin in the form of droplets, along a trajectory towards a plasma formation region 4. During the running of such an LPP radiation source, not all the fuel droplets may be intercepted by drive laser radiation 2 (e.g. during pauses in EUV emission), and so these droplets may be collected in a receptacle (not shown). The radiation source SO may include a receptacle which contains captured fuel which may be provided to the fuel emitter 3 for reuse.

The drive laser radiation 2 is incident upon the tin at the plasma formation region 4. The deposition of drive laser energy into the tin creates a tin plasma 7 at the plasma formation region 4. Radiation, including EUV radiation, is emitted from the plasma 7 during de-excitation and recombination of electrons with ions of the plasma. The EUV radiation from the plasma is collected and focused by a collector 5. The collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The drive laser 1 may be spatially separated from the radiation source SO. Where this is the case, the drive laser radiation 2 may be passed from the drive laser 1 to the radiation source SO with the aid of a beam delivery system (not shown) comprising, for example, suitable directing mirrors and/or a beam expander, and/or other optics. The drive laser 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO. The opening 8 may be referred to as an optical aperture 8.

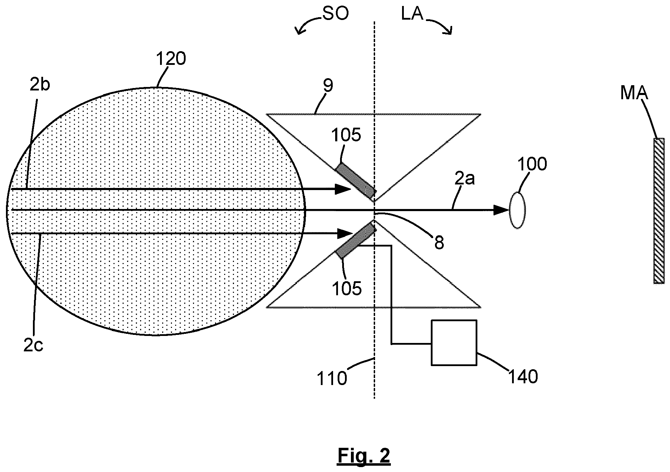

Fig. 2 schematically depicts a simplified view of the lithographic system of Fig. 1 at a time when at least a portion of drive laser radiation 2a propagates through the optical aperture 8. The optical aperture 8 may be formed by an opening in the enclosing structure 9 of the radiation source SO. The optical aperture 8 may be thought of as being located on a dividing line 110 between the radiation source SO and the lithographic apparatus LA. It will be appreciated that the dividing line 110 is not a physical structure and is merely shown to aid understanding of Fig. 2. In the example of Fig. 2, three portions of drive laser radiation 2a-c are shown. A first portion 2a of the drive laser radiation propagates through the optical aperture 8 and thereby travels from the radiation source SO to the lithographic apparatus LA. Drive laser radiation 2a entering the lithographic apparatus LA through the optical aperture 8 may negatively affect one or more components in the lithographic apparatus LA. The drive laser radiation 2a may transfer heat to the one or more components and thereby cause unwanted thermal deformation of the one or more components. The drive laser radiation 2a may damage the components and thereby reduce an operational lifetime of the components. This in turn, may necessitate more frequent repairs and/or maintenance of the components, thereby reducing the amount of time for which the lithographic system may remain operational. For example, unwanted thermal deformation and/or damage to components such as the one or more mirrors 10, 11, 13, 14 (shown in Fig. 1), the patterning device MA and/or the substrate W (shown in Fig. 1) caused by the drive laser radiation 2a may reduce an imaging performance of the lithographic apparatus LA, e.g. by introducing focus errors and/or overlay errors.

The lithographic apparatus LA comprises a radiation shield 100 configured to block the portion of the drive laser radiation 2a that propagates through the optical aperture 8. The radiation shield 100 acts to protect components of the lithographic apparatus LA from the negative effects of unwanted thermal deformation and/or damage to components caused by the drive laser radiation 2a. However, the location of the radiation shield 100 relative to fuel debris 120 generated in the radiation source SO is important.

The radiation source SO generates fuel debris 120 (e.g. tin debris) in the process of generating EUV radiation. If the radiation shield 100 is located in the radiation source SO, then the radiation shield 100 may become contaminated by fuel debris 120 (e.g. molten tin) and then later emit said fuel debris 120 through the optical aperture 8 and into the lithographic apparatus LA. The emission of fuel debris 120 from the radiation shield 100 may be caused by the high temperatures (e.g. greater than 1000°C) reached during operation of the radiation SO and/or chemical effects occurring within the radiation source SO. For example, molten tin 120 may collect on the radiation shield 100 and subsequently be released from the radiation shield 100 when the drive laser radiation 2a heats the radiation shield 100 to a temperature greater than the melting point of tin. As another example, hydrogen gas may be provided to the radiation source SO to reduce fuel debris 120 contamination of surfaces within the radiation source SO. The hydrogen gas may be heated to convert the hydrogen gas into free radicals that can remove contamination from said surfaces within the radiation source SO. However, the free radicals may interact with the molten tin 120, thereby causing small particles of tin to be ejected from the surfaces of the radiation shield 100. This phenomenon may be referred to as "tin spitting".

If the radiation shield 100 is located in the radiation source SO, then the fuel debris released from the radiation shield 100 (e.g. by tin spitting) may travel through the optical aperture 8, into the lithographic apparatus LA and negatively affect one or more components therein. For example, fuel debris may damage and/or otherwise reduce an operational lifetime of one or more mirrors 10, 11, 13, 14 (shown in Fig. 1) of the lithographic apparatus LA. As another example, if the radiation shield 100 is located in the radiation source SO, then the fuel debris emitted by the radiation shield 100 may be incident on the patterning device MA and/or the substrate W present in the lithographic apparatus LA and may reduce an imaging performance of the lithographic apparatus LA, e.g. by introducing focus errors and/or overlay errors. This may in turn result in faulty devices being manufactured by the lithographic apparatus LA.

By locating the radiation shield 100 in the lithographic apparatus LA rather than the radiation source SO, contamination of the radiation shield 100 by fuel debris 120 is reduced or avoided entirely. This significantly reduces the likelihood of the radiation shield 100 becoming a source of fuel debris, and thereby reduces contamination of the lithographic apparatus LA with fuel debris 120 when compared to locating the radiation shield 100 in the radiation source SO.

Locating the radiation shield 100 in the radiation source SO may disturb an intended flow of hydrogen gas and/or free radicals within the radiation source SO, which may in turn reduce decontamination of surfaces within the radiation source SO. For example, the part of the structure 9 that forms the optical aperture 8 in the radiation source SO and separates the fuel debris rich environment of the radiation source SO from the cleaner environment of the lithographic apparatus LA may be referred to as a fuel shield 9. Fuel debris 120 is incident on the fuel shield 9 during operation of the radiation source SO. In order to remove the fuel debris and thereby decontaminate the fuel shield 9, a flow of free radicals (not shown) may be provided along the fuel shield 9. Locating the radiation shield 100 in the radiation source SO proximate the fuel shield 9 may change an intended direction of the free radicals and/or introduce an undesired asymmetry in the flow of free radicals. This in turn may prevent one or more surface areas of the fuel shield 9 from being decontaminated by the free radicals, leading to problematic fuel debris accumulation on the one or more surface areas of the fuel shield 9. By locating the radiation shield 100 in the lithographic apparatus LA rather than the radiation source SO, the flow of hydrogen gas and/or free radicals is not disturbed. This significantly reduces fuel debris 120 accumulation on surfaces of the radiation source SO, such as the fuel shield 9, when compared to locating the radiation shield 100 in the radiation source SO.

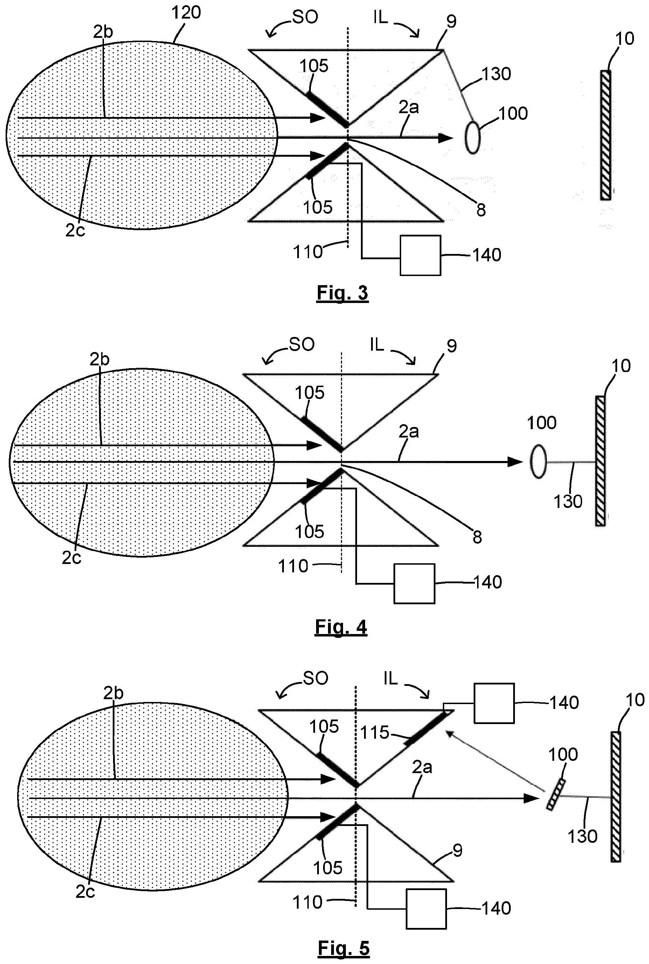

In general, the radiation source SO environment is operated under more extreme conditions compared to the lithographic apparatus LA. For example, the radiation source SO reaches temperatures greater than 1000°C and is exposed to fuel debris 120 whereas the lithographic apparatus LA does not reach such extreme temperatures and is exposed to little or no fuel debris 120. As another example, the radiation shield 100 may be exposed to less drive laser radiation 2a when located in the lithographic apparatus LA compared to the radiation source SO because the fuel shield 9 may block portions of drive laser radiation 2b, 2c that otherwise may be incident on the radiation shield 100. As such, the radiation shield 100 may be subjected to a lower heat load when located in the lithographic apparatus LA rather than the radiation source SO. By locating the radiation shield 100 in the lithographic apparatus LA rather than the radiation source SO, the radiation shield 100 is exposed to less extreme conditions. As such, greater design flexibility of the radiation shield 100 is enabled. For example, because less drive laser radiation 2a power is incident on the radiation shield 100 when the radiation shield is located in the lithographic apparatus LA rather than the radiation source SO, the radiation shield 100 may require less material to absorb the associated heat load. As such, the radiation shield 100 and/or an arm (shown and described in relation to Figs. 3-5) configured to support the radiation shield 100 may be more compact and/or lighter when the radiation shield 100 is located in the lithographic apparatus LA rather than the radiation source SO. As another example, because the drive laser radiation 2a beam diameter may be smaller in the lithographic apparatus LA compared to in the radiation source SO (e.g. due to proximity to the intermediate focus 6). As such, the radiation shield 100 may require a smaller size to block the portion of drive laser radiation 2a that passes through the optical aperture 8 may therefore be more compact and/or lighter when the radiation shield 100 is located in the lithographic apparatus LA rather than the radiation source SO. Given that the radiation shield 100 is more compact and/or lighter, the arm (shown and described in relation to Figs. 3-5) may also be smaller. A size of the radiation shield 100 may be at least two times smaller, e.g. about five times smaller, when the radiation shield 100 is located in the lithographic apparatus LA rather than the radiation source SO.

By making the radiation shield 100 more compact, a transmission of EUV radiation through the lithographic apparatus LA may be improved. As other examples, the radiation shield 100 may be sized and/or shaped differently, and/or made from a greater range of materials when located in the lithographic apparatus LA compared to the radiation source SO.

With reference to Fig. 1, the EUV radiation B generated by the radiation source SO may take the form of a cone having a hole in its center. The hole in the cone of EUV radiation may correspond to the gap in the collector 5 through which drive laser radiation 2 is directed to the plasma formation region 7. The radiation shield 100 may be positioned within the lithographic apparatus LA at a position that coincides with the hole in the cone of EUV radiation B such that substantially no EUV radiation B is blocked by the radiation shield 100 whilst substantially all drive laser radiation 2a passing through the optical aperture 8 is blocked by the radiation shield 100. By locating the radiation shield 100 in the lithographic apparatus LA rather than the radiation source SO, it is possible to locate the radiation shield 100 in a position that coincides with the hole in the cone of EUV radiation B such that substantially no EUV radiation B is blocked by the radiation shield 100 whilst substantially all drive laser radiation 2a passing through the optical aperture 8 is blocked by the radiation shield 100.

By blocking the drive laser radiation 2a, the radiation shield 100 is configured to absorb (i.e. act as a beam dump), redirect (e.g. reflect) or otherwise prevent the drive laser radiation 2a from interacting with components of the lithographic apparatus LA that are not intended for interaction with the drive laser bream 2a. As such, the design of the radiation shield 100 may be at least partially determined by the characteristics of the drive laser radiation 2a that is expected to be incident upon the radiation shield 100 along with the associated heat load. For example, the drive laser radiation 2a may have a wavelength within the inclusive range of between about 9 µm and about 11 µm. For example, the drive laser radiation 2a may have a power of between about 10 kW and about 50kW. The radiation shield 100 may be formed of a metal such as, for example, tungsten or molybdenum. The radiation shield 100 may be configured to block all drive laser radiation 2a that propagates through the optical aperture 8. A size and/or shape of the radiation shield 100 may be at least partially determined by a spatial extent (e.g. a beam diameter) of the drive laser radiation 2a at a location at which the radiation shield 100 is to be placed. The radiation shield 100 may have a diameter that is slightly greater than the beam diameter of the drive laser radiation 2a to ensure that the drive laser radiation 2a is blocked. For example, the drive laser radiation 2a may have a beam diameter within the inclusive range of between about 0.6 cm and about 2 cm, whereas the radiation shield 100 may have a diameter that is greater than the beam diameter of the drive laser radiation 2a and within the inclusive range of between about 1 cm to about 5 cm. A spatial extent of the portion of drive laser radiation 2a that propagates through the optical aperture 8 may be at least partially determined by a spatial extent (e.g. a diameter) of the optical aperture 8. For example, the optical aperture 8 may have a diameter of between about 3 mm and about 12 mm.

As previously discussed, by locating the radiation shield 100 in the lithographic apparatus LA rather than the radiation source SO, a greater portion of the drive laser radiation 2b, 2c may be incident upon a surface of the radiation source SO such as, for example, the fuel shield 9. For example, an additional kW of drive laser radiation 2b, 2c may be incident on the fuel shield 9 when the radiation shield 100 is located in the lithographic apparatus LA. The radiation source SO may comprise a first beam dump 105 configured to block at least a portion of the drive laser radiation 2b, 2c that does not propagate through the optical aperture 8. The first beam dump 105 may be provided on one or more areas of the fuel shield 9 that are expected to receive drive laser radiation 2b, 2c. The first beam dump 105 may be configured to absorb substantially all of the drive laser radiation 2b, 2c incident on the first beam dump 105. As such, the design of the first beam bump 105 may be at least partially determined by the characteristics of the drive laser radiation 2b, 2c that is expected to be incident upon the first beam dump 105 along with the associated heat load. The first beam dump 105 may be formed of a metal such as, for example, tungsten, molybdenum or copper.

The radiation shield 100 may be located proximate the optical aperture 8. The radiation shield 100 may be located closer to the optical aperture 8 than any other component of the lithographic apparatus LA. For example, the radiation shield 100 may be located at a distance within the inclusive range of between about 10 cm and about 1 m from a center of the optical aperture 8. This may reduce or remove the risk of the radiation shield 100 disturbing the EUV radiation propagating through the optical aperture 8 to the lithographic apparatus LA and/or interfering with components of the lithographic apparatus LA (e.g. mirrors 10, 11 shown in Fig. 1). In addition, a spatial extent of the portion of drive laser radiation 2a that propagates through the optical aperture 8 may be at least partially determined by a beam divergence of the drive laser radiation 2a. By locating the radiation shield 100 proximate the optical aperture 8, the portion of the drive laser beam 2a is blocked before it can diverge any further, and a risk of the portion of drive laser radiation 2a interacting with components of the lithographic apparatus LA is reduced.

Figs 3-5 show examples of different locations of the radiation shield 100 in the lithographic apparatus LA according to embodiments of the present disclosure. As discussed above, the lithographic apparatus LA comprises an illumination system IL, and in the examples of Figs. 3-5 the radiation shield 100 is located at different positions within the illumination system IL. In the example of Fig. 3, the radiation shield 100 is attached to the fuel shield 9. In the examples of Fig. 4 and Fig. 5, the radiation shield 100 is attached to the faceted field mirror device 10 of the illumination system IL. In each of the examples of Figs 3-5, the radiation shield 100 is attached to a component of the lithographic system by an arm 130. The arm 130 may be a rod configured to support the radiation shield 130. The arm 130 may be formed of metal such as, for example, aluminum or steel. The arm 130 may be configured to hold the radiation shield 100 in a fixed position relative to the optical aperture 8.

In the examples of Figs. 3 and 4, the radiation shield 100 is configured to act as a beam dump and absorb substantially all of the portion of the drive laser radiation 2a that propagates through the optical aperture 8. In the example of Fig. 5, the radiation shield 100 is configured to act as a reflector and redirect the portion of drive laser radiation 2a that propagates through the optical aperture 8 towards a second beam dump 115. When configured to act as a reflector, the radiation shield 100 may be configured to reflect substantially all of the drive laser radiation 2a incident on the radiation shield 100. As such, the design of the radiation shield 100 may be at least partially determined by the characteristics of the drive laser radiation 2a that is expected to be incident upon the radiation shield 100. When configured to act as a reflector, the radiation shield 100 may be formed of a metal, such as aluminum or steel. When configured to act as a reflector, the radiation shield 100 may comprise a multilayer mirror configured to reflect the drive laser radiation 2a wavelength (e.g. between about 9 µm and about 11 µm). When configured to act as a reflector, the radiation shield 100 may comprise a similar mirror structure to that utilized in the drive laser 1.

In the example of Fig. 5, the second beam dump 115 is provided on an upper surface of the fuel shield 9. The second beam dump 115 may be provided elsewhere on the fuel shield 9 or on another component of the illumination system IL. The second beam dump 115 may be configured to absorb substantially all of the drive laser radiation 2a incident on the second beam dump 115. As such, the design of the second beam bump 115 may be at least partially determined by the characteristics of the drive laser radiation 2a that is expected to be incident upon the second beam dump 115 along with the associated heat load. The second beam dump 105 may be formed of a metal such as, for example, tungsten, molybdenum or copper. The first and/or second beam dumps 105, 115 may act to reduce or prevent unwanted thermal deformation of the fuel shield 9.

Throughout Figs. 2-5, the lithographic system comprises a cooling system 140. In the examples of Figs. 2-4, the cooling system 140 is configured to actively cool the first beam dump 105. In the example of Fig. 5, the cooling system 140 is configured to actively cool the first and second beam dumps 105, 115. The cooling system 140 may comprise one or more channels configured to convey a cooling fluid. The cooling fluid may, for example, be water. The channels may contact and/or be located proximate the first and/or second beam dumps 105, 115 to allow heat energy to transfer from the first and/or second beam dumps 105, 115 to the cooling fluid. The cooling fluid may then be directed away from the first and/or second beam dumps 105, 115 to a heat dump and/or a temperature regulator for removing the absorbed heat energy from the cooling fluid. The cooled cooling fluid may then be redirected through the channels towards the first and/or second beam dumps 105, 115 thereby provided a continuous cooling cycle. The lithographic system may comprise one or more pre-existing cooling systems that may be modified to provide cooling of the first and/or second heat dumps 105, 115.

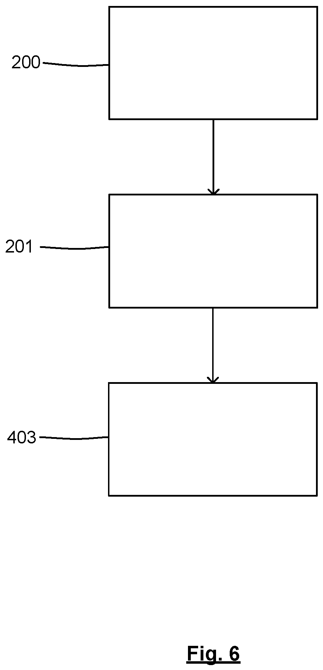

Fig. 6 shows a flowchart of a method of providing extreme ultraviolet radiation to a lithographic apparatus according to an embodiment of the present disclosure. A first step 200 of the method comprises irradiating a fuel with drive laser radiation to generate extreme ultraviolet radiation. The first step 200 may comprise using an LPP radiation source, such as the radiation source SO shown in Fig. 1. A second step 201 of the method comprises directing the extreme ultraviolet radiation to the lithographic apparatus through an optical aperture. The second step 201 of the method may comprise using the radiation collector 5 to direct EUV radiation B through the optical aperture 8 of the lithographic system of Fig. 1. A third step 202 of the method comprises blocking at least a portion of drive laser radiation that propagates through the optical aperture. The third step 202 of the method may comprise utilizing the radiation shield 100 shown in any of the examples of Figs. 1-5.

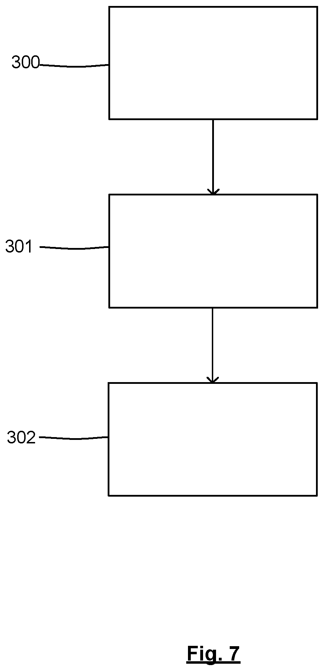

Fig. 7 shows a flowchart of a method of manufacturing a lithographic system according to an embodiment of the present disclosure. A first step 300 of the method comprises providing a radiation source comprising a drive laser configured to generate drive laser radiation for irradiating a fuel and thereby generating extreme ultraviolet radiation. The first step 300 of the method may comprise providing an LPP radiation source SO such as the one shown in Fig. 1. A second step 301 of the method comprises providing a lithographic apparatus configured to receive extreme ultraviolet radiation directed through an optical aperture located between the radiation source and the lithographic apparatus. The second step 301 of the method may comprise providing an EUV lithographic apparatus LA such as the one shown in Fig. 1 and arranging the lithographic apparatus LA relative to the radiation source SO to form the optical aperture 8. A third step 302 of the method comprises arranging a radiation shield in the lithographic apparatus to block at least a portion of drive laser radiation that propagates through the optical aperture. The third step 302 of the method may comprise providing the radiation shield 100 of any of the examples of Figs. 1-5.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A lithographic system comprising:
a radiation source comprising a drive laser configured to generate drive laser radiation for irradiating a fuel and thereby generating extreme ultraviolet radiation; and,
a lithographic apparatus configured to receive extreme ultraviolet radiation directed through an optical aperture located between the radiation source and the lithographic apparatus,
wherein the lithographic apparatus comprises a radiation shield configured to block at least a portion of the drive laser radiation that propagates through the optical aperture.

2. The lithographic system of claim 1, wherein the radiation shield is configured to block all drive laser radiation that propagates through the optical aperture.

3. The lithographic system of claim 1 or claim 2, wherein the radiation shield is located proximate the optical aperture.

4. The lithographic system of any preceding claim, wherein the lithographic apparatus comprises an illumination system configured to condition the extreme ultraviolet radiation beam for illumination of a patterning device, the illumination system comprising a mirror configured to reflect the extreme ultraviolet radiation, wherein the radiation shield is attached to the mirror.

5. The lithographic system of any preceding claim, wherein the lithographic apparatus comprises an illumination system configured to condition the extreme ultraviolet radiation beam for illumination of a patterning device, the illumination system comprising a fuel shield configured to protect a component of the illumination system from fuel debris generated by the radiation source, wherein the radiation shield is attached to the fuel shield.

6. The lithographic system of any preceding claim, wherein the radiation source comprises a first beam dump configured to block at least a portion of the drive laser radiation that does not propagate through the optical aperture.

7. The lithographic system of claim 6, wherein the lithographic apparatus comprises a second beam dump, and wherein radiation shield comprises a mirror configured to direct the portion of the drive laser radiation that propagates through the optical aperture towards the second beam dump.

8. The lithographic system of claim 7, wherein the first beam dump and/or the second beam dump is arranged on a structure that forms the optical aperture.

9. The lithographic system of claim 7 or claim 8, comprising a cooling system configured to actively cool the first beam dump and/or the second beam dump.

10. The lithographic system of any preceding claim, wherein the radiation source is configured to generate a cone of extreme ultraviolet radiation, wherein the cone comprises a hole in which no extreme ultraviolet radiation is present, and wherein the radiation shield is located at a position in the lithographic apparatus that at least partially coincides with the hole of the cone of extreme ultraviolet radiation.

11. A method of providing extreme ultraviolet radiation to a lithographic apparatus comprising:
irradiating a fuel with drive laser radiation to generate extreme ultraviolet radiation;
directing the extreme ultraviolet radiation to the lithographic apparatus through an optical aperture;
and,
blocking at least a portion of drive laser radiation that propagates through the optical aperture.

12. The method of claim 11, comprising blocking all drive laser radiation that propagates through the optical aperture.

13. The method of claim 11 or claim 12, comprising blocking at least a portion of the drive laser radiation that does not propagate through the optical aperture.

14. The method of claim 13, comprising using active cooling to dissipate heat generated by blocking the portion of the drive laser radiation that does not propagate through the optical aperture.

15. A method of manufacturing a lithographic system comprising:
providing a radiation source comprising a drive laser configured to generate drive laser radiation for irradiating a fuel and thereby generating extreme ultraviolet radiation;
providing a lithographic apparatus configured to receive extreme ultraviolet radiation directed through an optical aperture located between the radiation source and the lithographic apparatus; and,
arranging a radiation shield in the lithographic apparatus to block at least a portion of drive laser radiation that propagates through the optical aperture.

16. The method of claim 15, comprising locating the radiation shield proximate the optical aperture.

17. The method of claim 15 or claim 16, wherein the lithographic apparatus comprises an illumination system configured to condition the extreme ultraviolet radiation beam for illumination of a patterning device, the illumination system comprising a mirror configured to reflect the extreme ultraviolet radiation,
the method comprising attaching the radiation shield to the mirror.

18. The method of claim 15 or claim 16, wherein the lithographic apparatus comprises an illumination system configured to condition the extreme ultraviolet radiation beam for illumination of a patterning device, the illumination system comprising a fuel shield configured to protect a component of the illumination system from fuel debris generated by the radiation source,
the method comprising attaching the radiation shield to the fuel shield.

19. The method of any of claims 15 to 18, comprising providing a first beam dump configured to block at least a portion of the drive laser radiation that does not propagate through the optical aperture.

20. The method of claim 19, comprising providing a second beam dump configured to block the portion of the drive laser radiation that propagates through the optical aperture.

21. The method of claim 20, comprising arranging the first beam dump and/or the second beam dump on a structure that forms the optical aperture.

22. The method of claim 20 or claim 21, comprising providing a cooling system configured to actively cool the first beam dump or the second beam dump.

23. The method of any of claims 15 to 22, wherein the radiation source is configured to generate a cone of extreme ultraviolet radiation, wherein the cone comprises a hole in which no extreme ultraviolet radiation is present,
Wherein the method comprises locating the radiation shield at a position in the lithographic apparatus that at least partially coincides with the hole of the cone of extreme ultraviolet radiation.
